# EUROPEAN PATENT APPLICATION

(11) **EP 0 623 962 A1**
(43) Date of publication of application: **09.11.1994**
(21) Application number: 94106756.3
(22) Date of filing: 29.04.1994
(51) Int. Cl.: H01L 29/784, H01L 29/60, H01L 29/62

(54) **Gate electrode of power MOS field effect transistor**

(30) Priority: 05.05.1993 DE 4314919
(71) Applicant: TEXAS INSTRUMENTS DEUTSCHLAND GMBH, D-85356 Freising (DE)
(72) Inventor: Wagensohner, Konrad, D-8054 Mauern (DE)
(74) Representative: Schwepfinger, Karl-Heinz, Dipl.-Ing.

(57) **Abstract**

A power MOS field-effect transistor has a plurality of cells identically configured in a semiconductor substrate (18), each containing a source zone (S), a drain zone (D) and a gate (G) of polycrystalline silicon. All cells are circuited in parallel by connecting the source zones (S), the drain zones (D) and the gates (G). The gates (G) of the cells are interconnected by a conductive layer of metal. (14, 16).

## Description

The invention relates to a power MOS field-effect transistor having a plurality of cells identically configured in a semiconductor substrate, each containing a source zone, a drain zone and a gate of polycrystalline silicon, whereby all cells are connected in parallel by connecting the source zones, the drain zones and the gates.

Currently popular power MOS field-effect transistors are fabricated with gates of polycrystalline silicon, this being the case, because when using this material in the course of the fabrication process high accuracy can be achieved as regards the positioning of the gates with respect to the other function zones of the transistor. In addition, by using this material for the gates the capacitances on the edges of the gates are held small so that these capacitances have no significant effects on the switching speed of the transistor. Since the individual gates of current popular power MOS field-effect transistors are interconnected by a layer of polycrystalline material, drawbacks result as regards the switching behaviour of the transistor. Polycrystalline silicon has namely a relatively high specific resistance resulting in the gate resistance together with the gate capacitance forming an RC element which reduces the switching speed of the transistor. In particular transit time problems occur resulting in not all cells of the transistor switching at the same time. Instead, due to the delay introduced by the RC element and depending on their location on the semiconductor substrate the cells are switched forward or reverse in a staggered sequence when the switching signals are applied. What is wanted, however, is that the cells connected in parallel behave, at best, as though they were a single cell. This is only possible, however, when all cells assume each wanted switching status in unison. This problem of the delay in switching is particularly a nuisance when high switching speeds are involved.

The object of the invention is based on configuring a power MOS field-effect transistor of the aforementioned kind so that it can also be employed at high switching speeds.

According to the invention this object is achieved by interconnecting the gates of the cells by a conductive layer of metal.

By interconnecting the gates metallically a control signal applied to the gate connection of the MOS field-effect transistor is applied to all gates of the cells forming the field-effect transistor practically without delay so that accordingly all cells are able to change their switching condition (conducting or non-conducting) practically at the same time according to the control signal applied. The power MOS field-effect transistor thus behaves as if only a single cell were involved which, however, to achieving the wanted switching capacity is dimensioned sufficiently large.

One advantageous embodiment of the invention is characterized in claim 2. In this embodiment the source zones and the drain zones are formed by elongated diffusion zones arranged alternately one alongside the other in the semiconductor substrate, by channel zones over which the gates of polycrystalline silicon are located, being disposed in the semiconductor substrate on both sides and directly bordering the source zones, by the gates being extended beyond the region of the substrate surface taken up by the source and drain zones and connected together in this region by a metallic conductive layer.

An example of the invention will now be explained in more detail with reference to the drawing in which:
- Fig. 1: is a schematic plan view of part of a power MOS field-effect transistor according to the invention and
- Fig. 2: is a schematic section view of the power transistor according to Fig. 1 as shown along the line 2-2 in Fig. 1.

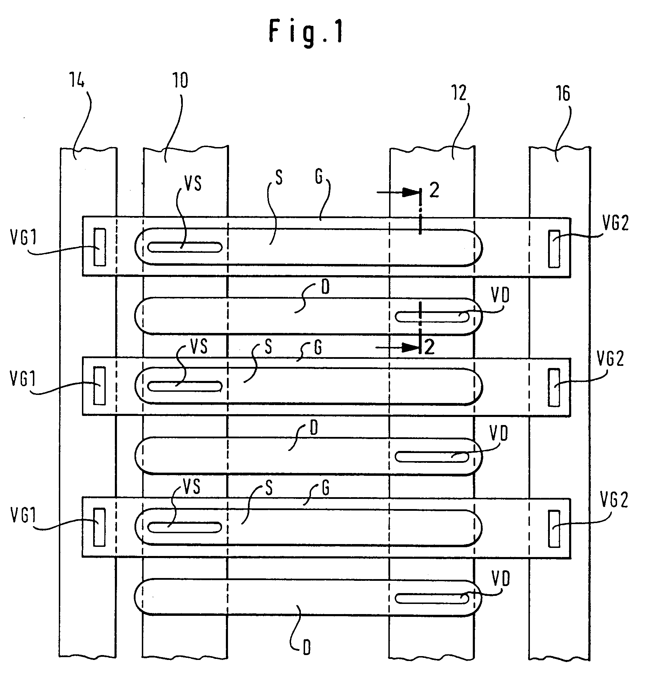

The schematic representation illustrated in Fig. 1 shows (not true to scale) a section of a power MOS field-effect transistor which is made up of a plurality of single cells, three of which are shown in Fig. 1. Each cell comprises a source zone S, a drain zone D and a gate G. The source zones S are contacted via connections VS to a strip 10 of conductive material, and the drain zones are contacted to a conductive strip 12 via the contacts VD. In the example shown the gates G are extended on both sides of the source zone S and connected on the one hand via contact connections VG1 and, on the other, via VG2 to the conductive strips 14 and 16 respectively. These conductive strips 14 and 16 are made of metal, for example, aluminum. It is to be noted that it is already sufficient to extend the length of the gates G merely on one side of the source zones S and to connect them with the aid of the conductive strip, except that in the embodiment shown in Fig. 1 a two-sided connection is preferred via the strips 14 and 16 of metal.

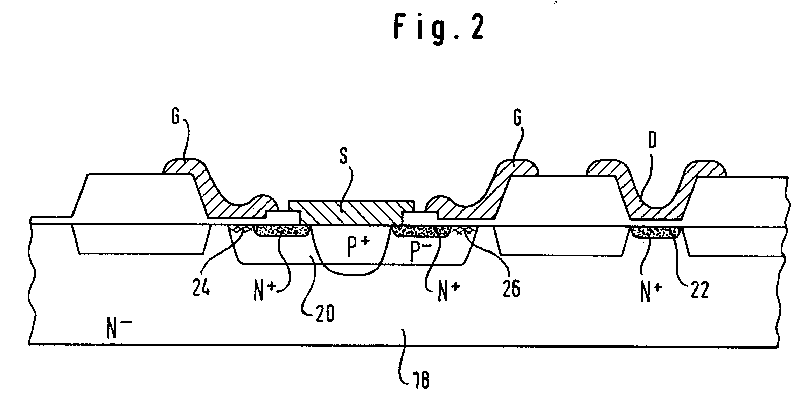

The section shown in Fig. 2 along the line 2-2 of Fig. 1 shows the basic configuration of a cell of the power MOS field-effect transistor described in the present. The transistor is formed in a semiconductor substrate 18 of (N⁻) doped silicon. In this semiconductor substrate 18 a (P⁻) conducting zone 20 is formed, in the middle of which a (P⁺) conducting zone is provided, forming the actual source zone. The drain zone is generated by a (N⁺) conducting zone 22. On both sides of the source zone S, i.e. in the (P⁻) conducting zone 20 two (N⁺) conductive regions are formed which are assigned to the gate G which extends on both sides of the source zone S. Each of the gates comprises polycrystalline silicon. The conductive strips 14 and 16 of metal cannot be seen from the illustration in Fig. 2.

When a control voltage is applied to the gate G channel zones 24, 26 are formed on both sides of the source zone S in the zone 20 which permit control of the flow of current between each of the source zones S and the drain zones D by conventional means. Connecting the gates G by means of the metallic conductive layer 14, 16 results in the control signal applied to the gates G being available at all channel zones 24, 26 practically at the same time so that accordingly simultaneous control of the aforementioned flow of current is also achieved.

## Claims

1. A power MOS field-effect transistor having a plurality of cells identically configured in a semiconductor substrate, each containing a source zone, a drain zone and a gate of polycrystalline silicon, in all cells being connected in parallel by connecting the source zones, the drain zones and the gates, characterized by the gates (G) of the cells being interconnected by a conductive layer of metal (14, 16).

2. A power MOS field-effect transistor according to claim 1 characterized in that the source zones (S) and the drain zones (D) are formed by elongated diffusion zones arranged alternately one alongside the other in the semiconductor substrate (18), that channel zones over which the gates of polycrystalline silicon are located (24,26) are disposed in the semiconductor substrate (18) on both sides and directly bordering the source zones (S) and that the gates (G) are extended beyond the region of the substrate surface taken up by the source and drain zones and interconnected in this region by a metallic conductive layer (14,16).
